# EUROPÄISCHE PATENTSCHRIFT

(11) **EP 2 414 558 B1**
(45) Veröffentlichungstag und Bekanntmachung des Hinweises auf die Patenterteilung: **11.11.2015**
(21) Anmeldenummer: 10712725.0
(22) Anmeldetag: 17.03.2010
(51) Int. Cl.: B82Y 30/00, C23C 16/30, C23C 16/32

(54) **MIT SIC BESCHICHTETE KÖRPER UND VERFAHREN ZUR HERSTELLUNG SIC-BESCHICHTETER KÖRPER**
BODIES COATED BY SIC AND METHOD FOR CREATING SIC-COATED BODIES
CORPS REVÊTU DE SIC ET PROCÉDÉ DE FABRICATION DE CORPS REVÊTUS DE SIC

(30) Priorität: 02.04.2009 DE 102009002129
(43) Veröffentlichungstag der Anmeldung: 08.02.2012
(73) Patentinhaber: Spawnt Private S.à.r.l., 1148 Luxembourg (LU)
(72) Erfinder: ENDLER, Ingolf, 01640Coswig (DE); HÖHN, Mandy, 01277 Dresden (DE); GEBEL, Thoralf, 01465 Dresden (DE); BAUCH, Christian, 06766 Bitterfeld-Wolfen (DE); DELTSCHEW, Rumen, 04319 Leipzig (DE); HOLL, Sven, 65558 Gückingen (DE); LIPPOLD, Gerd, 04179 Leipzig (DE); MOHSSENI-ALA, Seyed-Javad, 06766 Bitterfeld-Wolfen (DE); AUNER, Norbert, 61479 Glashütten (DE)
(74) Vertreter: Epping - Hermann - Fischer
(86) Internationale Anmeldenummer: PCT/EP2010/053436
(87) Internationale Veröffentlichungsnummer: WO 2010/112339

(56) Entgegenhaltungen:
- US-A1- 2004 222 501
- MOTOJIMA S ET AL: "Deposition and microhardness of SiC from the Si2Cl6-C3H8-H2-Ar system" JOURNAL OF MATERIALS SCIENCE UK, Bd. 21, Nr. 4, April 1986 (1986-04), Seiten 1363-1367, XP002588315 ISSN: 0022-2461
- GIUNTA G ET AL: "Investigation of interfaces of chemically vapour deposited SiC, SiC-Ti(N,C) multilayer coatings on WC-Co based cermets" SURFACE AND COATINGS TECHNOLOGY, ELSEVIER, AMSTERDAM, NL LNKD- DOI:10.1016/0257-8972(91)90051-W, Bd. 49, Nr. 1-3, 10. Dezember 1991 (1991-12-10), Seiten 174-180, XP024500157 ISSN: 0257-8972 [gefunden am 1991-12-10] in der Anmeldung erwähnt
- VLADIMIR SEVASTYANOV, YURIJ EZHOV, ROMAN PAVELKO, NIKOLAJ KUZNETSOV: "PERCHLOROSILANES AND PERCHLOROCARBOSILANES AS PRECURSORS TO SILICON CARBIDE" MATERIALS RESEARCH SOCIETY SYMPOSIUM PROCEEDINGS, Bd. 911, B05-12, 2006, Seiten 301-307, XP002588316

## Beschreibung

Die Erfindung betrifft Körper, beschichtet mit einer SiC-Schicht oder mit einem Schichtsystem, das mindestens eine SiC-Schicht enthält, sowie Verfahren zur Herstellung derartig beschichteter Körper.

Nanokristalline nc-3C-SiC- und amorphe a-SiC-Schichten mit unterschiedlicher Zusammensetzung werden für Anwendungen in der Mikroelektronik, Photovoltaik und als Oxidationsschutzschicht beschrieben. Neben den kristallinen SiC-Schichten mit kubischen Struktur, die als beta- oder 3C-SiC-Schichten bezeichnet werden, gibt es auch kristalline alpha-SiC-Schichten, die nur bei hohen Temperaturen über 1300°C erhältlich sind (C.H. Carter, V.F.Tsvetkov, R.C. Glass, D. Henshall, M. Brady, St.G. Müller, O. Kordina, K. Irvine, J.A. Edmond, H.-S. Kong, R. Sing, S.T. Allen, J.W. Palmour, Materials Science and Engineering B61-62 (1999) 1-8). Diese Hochtemperaturmodifikation ist nur für einige Mikroelektronikanwendungen relevant. Bekannt sind auch wasserstoffhaltige 3C-SiC-Schichten, die auch nanokristallin sein können. Ein Halbleiterbauelement mit wasserstoffhaltigem mikrokristallinen µc-SiC:H wird in der Patentanmeldung EP 1 950 810 A2 beschrieben. Für die Photovoltaik wird wasserstoffhaltiges, nanokristallines nc-3C-SiC:H als Fensterschicht in Heterojunction-Solarzellen angewendet (S. Miyajima, M. Sawamura, A. Yamada, M. Konagai, Journal of Non-Crystalline Solids 354 (2008) 2350-2354). Solche Schichten sind durch einen hohen Wasserstoffgehalt gekennzeichnet, der eine Anwendung als Verschleißschutzschicht ausschließt, wenn die Temperaturbelastungen über 500°C liegen (A.K. Costa, S.S. Camargo, Surface and Coatings Technology 163-164 (2003) 176-180).

Wasserstofffreies SiC besitzt eine hohe Oxidationsbeständigkeit und wird deshalb auch als Oxidationsschutzschicht verwendet (H. Jian-Feng, L. Miao, W. Bo, C. Li-Yun, X. Chang-Kui, W. Jian-Peng, Carbon 47 (2009) 1189-1206).

Als Verschleißschutzschicht auf Werkzeugen und Bauteilen findet SiC bisher kaum Anwendung. Ursachen sind die hohe Sprödigkeit (H.O. Pierson, Handbook of Refractory Carbides and Nitrides, NOYES Publications, Westwood, New Jersey, U.S.A., 1996) und die Reaktivität mit Eisenwerkstoffen bei hohen Temperaturen (R.C. Schiepers, J.A. van Beek, F.J.J. van Loo, G. de With, Journal of the European Ceramic Society 11 (1993) 211-218). Nur in der Patentschrift US 3,011,912 und in zwei diesbezüglichen Literaturstellen gibt es Hinweise zu möglichen Anwendungen von kristallinen oder amorphen SiC-Schichten als Verschleißschutzschicht. Beschrieben wird ein Prozess zur Herstellung von beta-SiC-Schichten auf anorganischen Substraten. Diese Schichten enthalten kein Chlor, da chlorfreie Ausgangsstoffe verwendet werden. Als eine mögliche Anwendung wird eine verschleißmindernde Schutzschicht auf einem sehr speziellen Bauteil, auf Grammophonnadeln, angegeben. Zur genauen Struktur und zu Eigenschaften der beta-Schicht gibt es keine Angaben.

Die Herstellung kristalliner 3C-SiC-Schichten mit Kristallitgrößen > 0,3 µm auf Hartmetallsubstraten wird in einer wissenschaftlichen Publikation beschrieben (G. Giunta, M. Fiorini, V. Vittori, G. Marchesano, Surface and Coatings Technology 49 (1991) 174-180). Verwendet wird ein CVD-Prozess, der bei einer Temperatur von 1000°C mit Methyltrichlorsilan arbeitet. Aufgrund der hohen Beschichtungstemperatur ist eine Direktbeschichtung des Hartmetalls nicht möglich.

Es bilden sich schädliche Cobaltsilicide und die Haftfestigkeit ist ungenügend. Nur durch eine Verwendung von aufwendigen Zwischenschichtsystemen, die als Diffusionsbarriere wirken, kann das Hartmetall beschichtet werden.

In einer weiteren Publikation wird eine reine amorphe SiC-Schicht auf einem Hartmetallwerkzeug beschrieben, mit der eine Reduzierung des abrasiven Verschleißes in einem Tribometertest bis 700°C nachgewiesen wurde (A.K. Costa, S.S. Camargo, Surface and Coatings Technology 163-164 (2003) 176-180).

Nanokristalline und amorphe SiC-Schichten, die allerdings aus gesinterten Partikeln bzw. Clustern mit einer Größe von 50 nm bis 500 nm bestehen und damit keine homogene Struktur und Zusammensetzung besitzen, lassen sich mit einem DC-Plasmajet-CVD-Verfahren herstellen (J. Wilden, A. Wank, Galvanotechnik 91 (2000) Nr. 8, 2250-2256). Werden bei diesem Verfahren chlorhaltige Standardausgangsstoffe verwendet, wie Trimetylchlorsilan oder Trichlormethylsilan, weist die Schicht jedoch so hohe Chlorkonzentrationen auf, dass diese schädlich für die beschriebene Beschichtung von Stählen und Metallen sind. Die Chlorkonzentration ist insbesondere im Interfacebereich zum Substrat sehr hoch.

Der Erfindung liegt die Aufgabe zugrunde, Körper mit SiC-Schichten auszustatten, die eine partikelfreie, nichtporöse Struktur, eine hohe Härte, niedrige Sprödigkeit, hohe Haftfestigkeit, gute Oxidationsbeständigkeit und einen hohen Widerstand gegen Rissausbreitung besitzen.

Diese Aufgabe wird mit den in den Patentansprüchen enthaltenen Merkmalen gelöst, wobei die Erfindung auch Kombinationen der einzelnen abhängigen Ansprüche im Sinne einer UND-Verknüpfung mit einschließt.

Erfindungsgemäß sind die Körper mit einer SiC-Schicht oder mit einem mehrlagigen Schichtsystem, das mindestens eine SiC-Schicht enthält, beschichtet, wobei die SiC-Schicht aus halogenhaltigem nanokristallinem 3C-SiC oder aus einer Mischschicht besteht, welche aus halogenhaltigem nanokristallinem 3C-SiC und amorphem SiC oder aus halogenhaltigem nanokristallinem 3C-SiC und amorphem Kohlenstoff besteht.

Die SiC-Schicht weist gemäß der Erfindung eine clusterfreie, homogene Struktur auf. Das bedeutet, dass die Schicht keine übergeordnete Struktur aus Clustern bzw. Partikeln mit zusätzlichen, verfahrensbedingten Korngrenzen aufweist, wie dies im Gegensatz jedoch beim Stand der Technik (J. Wilden, A. Wank, Galvanotechnik 91 (2000) Nr. 8, 2250-2256) der Fall ist. Durch eine derartige clusterfreie Struktur werden unerwünschte Inhomogenitäten in der Zusammensetzung vermieden, die an solchen Partikelgrenzen unvermeidlich auftreten.

Nach weiteren Merkmalen der Erfindung besitzt die erfindungsgemäße SiC-Schicht eine clusterfreie, homogene Struktur und/oder ein porenfreies, dichtes Gefüge.

Gemäß einer vorteilhaften Ausgestaltung der Erfindung kann die SiC-Schicht ein periodisch oder kontinuierlich variierendes Verhältnis von halogenhaltigem nanokristallinem 3C-SiC zu amorphem SiC oder amorphem Kohlenstoff aufweisen.

Als Halogene sind vorzugsweise Cl, F, Br und/oder J in der SiC-Schicht enthalten.

Gemäß einer vorteilhaften Ausgestaltung der Erfindung liegt der Halogengehalt in der SiC-Schicht im Bereich von 0,0001 At.-% bis 2 At.-%.

Die Mischschicht weist amorphes SiC mit einem Anteil zwischen 0,5 Ma.-% bis 99,5 Ma.-%.

Das amorphe SiC weist ein C:Si-Atomverhältnis von 1 bis 1,2 auf.

Das nanokristalline 3C-SiC enthält amorphen Kohlenstoff mit einem Anteil von 0 bis 10 Ma-%.

Das nanokristallinen 3C-SiC besitzt eine Kristallitgröße < 200 nm.

Die SiC-Schicht weist eine Dicke im Bereich von 0,1 µm bis 100 µm auf.

Das mehrlagige Schichtsystem besteht aus mehreren SiC-Schichten oder aus mindestens einer SiC-Schicht und einer oder mehrer Schichten, ausgewählt aus einer Gruppe der Materialien TiN, TiCN, TiC, Al₂O₃ und Diamant.

Die SiC-Schicht kann unter Vermeidung einer Zwischenschicht unmittelbar auf dem Körper angeordnet sein.

Die SiC-Schicht oder das mehrlagige Schichtsystem ist erfindungsgemäß auf Körpern aus Metall, Hartmetall, Cermet oder Keramik als Verschleiß- oder Oxidationsschutzschicht aufgebracht. Die SiC-Schicht oder das mehrlagige Schichtsystem ist erfindungsgemäß auch für Anwendungen in der Mikroelektronik oder der Photovoltaik auf entsprechenden Substraten aufgebracht.

Zur Beschichtung von Körpern mit einer SiC-Schicht oder mit einem mehrlagigen Schichtsystem, das mindestens eine SiC-Schicht enthält, beinhaltet die Erfindung ein Verfahren, bei dem die Körper mittels eines thermischen CVD-Prozesses beschichtet werden, wobei eine Gasmischung verwendet wird, die H₂ und/oder eines oder mehrere Inertgase, eines oder mehrere der Halogenpolysilane der Formeln SiₙX₂ₙ, SiₙX₂ₙ₊₂, SiₙX_{y}H_{z}, worin X das Halogen und n ≥ 2 ist, sowie einen oder mehrere Kohlenwasserstoffe enthält.
Alternativ wird eine Gasmischung verwendet, die in H₂ und/oder einem oder mehreren Inertgasen eines oder mehrere, mit organischen Substituenten R substituierte Halogenpolysilane der allgemeinen Formeln SiₙX_{y}R_{z} oder SiₙHₓX_{y}R_{z} enthält, worin X das Halogen ist und n ≥ 2, z > 0, y ≥ 1 sind. Dabei gelten für SiₙX_{y}R_{z} die stöchiometrischen Beziehungen 2n+2 = y +z oder 2n=y+z und für SiₙHₓXyR_{z} die stöchiometrischen Beziehungen 2n+2 = x+y+z oder 2n=x+y+z. eingesetzt, wobei X= Cl, F, Br und/oder J sind.

Die Körper werden dabei mittels eines thermischen CVD-Prozesses bei Temperaturen zwischen 600°C und 950°C, vorzugsweise bei Temperaturen zwischen 600°C und 800°C beschichtet.

Als organischer Substituent kann vorteilhaft CH₃ dienen.

Als Halogenpolysilane mit organischen Substituenten können (CH₃)₂Si₂Cl₄ und/oder (CH₃)₄Si₂Cl₂ in der Gasmischung verwendet werden.

Als Kohlenwasserstoffe können Alkane, Alkene oder Alkine eingesetzt werden.

Als Kohlenwasserstoffe können CH₄, C₂H₄ oder C₂H₂ eingesetzt werden. Zweckmäßigerweise wird die Beschichtung in einem Heißwand-CVD-Reaktor bei einem Druck im Bereich von 1 kPa bis 9 kPa durchgeführt. Erfindungsgemäß wird das Verfahren zur Beschichtung von Körpern aus Metall, Hartmetall, Cermet oder Keramik mit einer Verschleiß- oder Oxidationsschutzschicht oder für Beschichtungen in der Mikroelektronik oder der Photovoltaik angewandt. Die erfindungsgemäßen SiC-Hartstoffschichten weisen eine Reihe sehr vorteilhafter Eigenschaften auf.

Die Schichten bestehen ausschließlich aus SiC-Nanokristallen oder aus SiC-Nanokristallen und amorphen Bereichen, die durch Kristallkorngrenzen voneinander abgegrenzt sind. Sie weisen jedoch keine übergeordnete Struktur aus Clustern bzw. Partikeln mit zusätzlichen, verfahrensbedingten Korngrenzen auf. Durch eine derartige clusterfreie Struktur werden unerwünschte Inhomogenitäten in der Zusammensetzung vermieden, die an solchen Partikelgrenzen unvermeidlich auftreten. Die SiC-Schichten besitzen eine hohe Härte, niedrige Sprödigkeit und hohe Haftfestigkeit und eignen sich zur Beschichtung von Körpern ohne Zwischenschichten.

Die erfindungsgemäßen Schichten weisen auch vorteilhaft eine dichte und homogene Struktur, eine hohe Härte und eine hohe Haftfestigkeit auf. Die Struktur aus nanokristallinem SiC bzw. nanokristallinem SiC mit Anteilen von amorphen SiC bzw. amorphem Kohlenstoff erlaubt eine sehr gute Beschichtung auch scharfkantiger Schneidkanten von Werkzeugen.

Da durch die Schichtstruktur durchgehende Korngrenzen von der Schichtoberfläche bis zum Substrat vermieden werden, wird bei hohen Einsatztemperaturen, wie sie z.B. in der Zerspanung auftreten, auch eine gute Oxidationsbeständigkeit und ein verbesserter Widerstand gegen Rissausbreitung erreicht.

Anteile des weicheren, amorphem SiC bzw. amorphen Kohlenstoffs führen überraschenderweise zu keinem Abfall der Härte gegenüber der reinen 3C-SiC-Schicht. Die Ausbildung einer Nanokompositstruktur wirkt in bestimmten Grenzen steigernd bzw. stabilisierend auf die Härte.

Ein weiterer Vorteil besteht in der Anwendung von nanokristallinen 3C-SiC-Schichten als haftungsverbessernde Anbindungsschicht in Substrat-Schichtverbunden. Sie können einerseits die Haftung nachfolgender Schichten auf keramischen Körpern, z.B. aus Si₃N₄, verbessern oder andererseits eine hohe Haftfestigkeit zu einer nachfolgenden Diamantschicht gewährleisten. Dies wird durch ihren niedrigen thermischen Ausdehnungskoeffizient und durch die nanokristalline Struktur erreicht. Eine besonders vorteilhafte Variante ist eine Schichtfolge aus nanokristallinem SiC und nanokristallinem Diamant, die auch eine Beschichtung scharfer Schneiden mit diesem hochleistungsfähigen Schichtsystem ermöglicht. Nanokristalline 3C-SiC-Schichten bzw. SiC-Schichten die aus nanokristallinem 3C-SiC und amorphem SiC oder amorphem Kohlenstoff bestehen, die Halogengehalte in einem optimalen Konzentrationsbereich aufweisen, wurden als Verschleißschutzschichten bisher nicht beschrieben. Diese Schichten sind nunmehr mit dem erfindungsgemäßen Verfahren herstellbar, das in vorteilhafter Weise die Einstellung optimaler Halogengehalte durch die Verwendung von Halogenpolysilanen bzw. substituierten Halogenpolysilanen in einem weiten Temperaturbereich erlaubt.

Da bei Halogenpolysilanen die Beschichtungstemperatur im Vergleich zu konventionellen Precursoren wie SiCl₄ oder Trichlormethylsilan deutlich niedriger gewählt werden kann, sind auch chemische Reaktionen zwischen dem Substratmaterial und den Precursoren vermeidbar. Damit ist auch eine Direktbeschichtung von metallischen Körpern möglich.

Auf Grund der guten Eigenschaften der erfindungsgemäßen SiC-Schichten und der günstigen Herstellungsparameter können die Schichten auch vorteilhaft in der Mikroelektronik verwendet werden.

Nachfolgend ist die Erfindung an Ausführungsbeispielen näher erläutert. Die zugehörigen Abbildungen zeigen:
- Abb. 1:: Das XRD-Diffraktogramm der nanokristallinen 3C-SiC-Schicht gemäß Beispiel 1,
- Abb. 2:: das XRD-Diffraktogramm der Mischschicht aus nanokristallinem 3C-SiC und amorphem SiC gemäß Ausführungsbeispiel 2,
- Abb. 3:: das Raman-Spektrum der Mischschicht aus nanokristallinen 3C-SiC-Schicht und amorphem SiC gemäß Ausführungsbeispiel 2,
- Abb. 4:: das XRD-Diffraktogramm der Mischschicht aus nanokristallinen 3C-SiC-Schicht und amorphem Kohlenstoff gemäß Ausführungsbeispiel 3,
- Abb. 5:: das Raman-Spektrum der Mischschicht aus nanokristallinen 3C-SiC-Schicht und amorphem Kohlenstoff gemäß Ausführungsbeispiel 3.

### Beispiel 1

Mittels eines CVD-Prozesses wird zunächst eine 1 µm dicke TiN-Anbindungsschicht und anschließend die erfindungsgemäße Schicht auf Si₃N₄-Keramikwendeschneidplatten abgeschieden.
Der Beschichtungsprozess erfolgt in einem Heißwand-CVD-Reaktor mit einem Innendurchmesser von 75 mm. Unter Verwendung der Gasmischung aus 0,3 Vol.-% Si₃Cl₈, 97,7 Vol.-% H₂ und 2,0 Vol.-% C₂H₄ bei einer Temperatur von 900°C und einem Druck von 9 kPa wird nach einer Beschichtungszeit von 120 min eine 3,5 µm dicke SiC-Schicht erhalten.

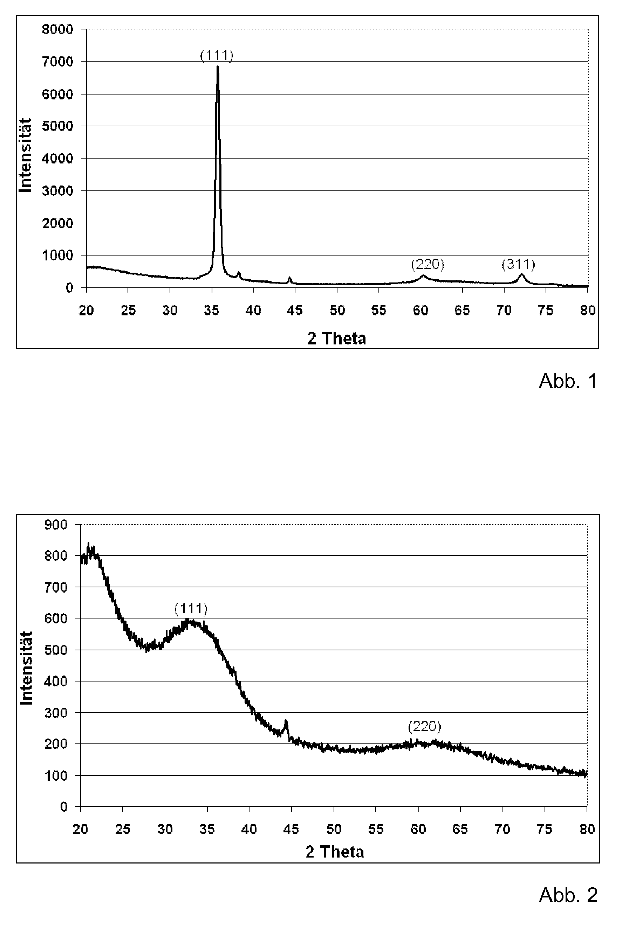

Diese Schicht wurde mittels röntgenographischer Dünnschichtanalyse im streifenden Einfall untersucht (siehe Röntgendiffraktogramm Abb. 1). Das Diffraktogramm zeigt eine <111> texturierte 3C-SiC-Schicht. Über die Scherrer-Gleichung wurde eine durchschnittliche 3C-SiC-Korngröße von 50 nm bestimmt.

Mittels WDX-Untersuchung wurde ein Chlorgehalt innerhalb der Schichten von 0,03 At.-% ermittelt.

Mikrohärtemessungen mit einem Vickers-Indenter ergaben eine Härte von 3850 HV[0.01].

Die erfindungsgemäße Schicht zeichnet sich durch eine glatte, homogene Oberfläche, eine nanokristalline Struktur sowie eine hohe Härte aus.

### Beispiel 2

Auf WC/Co-Hartmetallwendeschneidplatten mit einer Vorbeschichtung bestehend aus 1µm TiN und 2 µm TiCN wird die erfindungsgemäße Schicht mittels eines CVD-Prozesses aufgebracht.
Die Schichtabscheidung erfolgt ebenfalls in einem Heißwand-CVD-Reaktor mit einem Innendurchmesser von 75 mm. Eingesetzt wird eine Gasmischung aus 0,3 Vol.-% Si₃Cl₈, 93,7 Vol.-% H₂ und 6,0 Vol.-% C₂H₄ bei einer Temperatur von 800°C und einem Druck von 9 kPa. Die Schichtdarstellung erfolgte mit einer Abscheidungsrate von 0,5 µm/h.

Die Zusammensetzung der SiC-Schicht wurde mittels röntgenographischer Dünnschichtanalyse im streifenden Einfall ermittelt (siehe Röntgendiffraktogramm Abb. 2). Das Röntgendiffraktogramm zeigt breite Reflexe des 3C-SiC. Über die Scherrer-Gleichung wurde eine durchschnittliche Korngröße von 1 nm ermittelt.

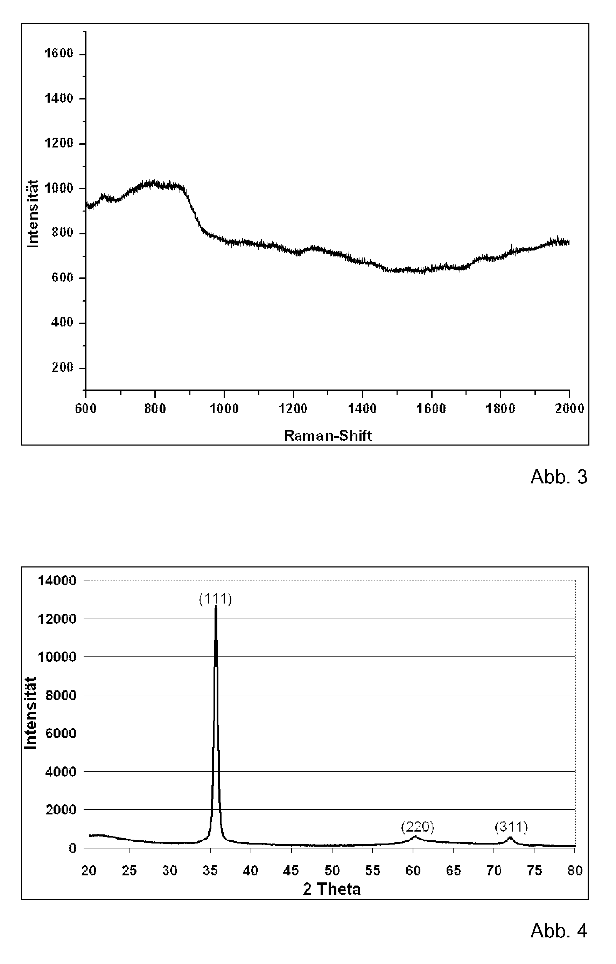

Raman-Untersuchungen (siehe Abb. 3) zeigen, dass die Peaks des 3C-SiC bei 780 cm⁻¹ und 890 cm⁻¹ nicht einzeln aufgelöst erscheinen, sondern es ist eine breite Bande bei 800 cm⁻¹ zu sehen, wie sie typisch für amorphes SiC ist. Erste Ansätze einer Auftrennung deuten auf eine beginnende Kristallisation. Die Schicht enthält keinen freien Kohlenstoff, da keine Peaks im Bereich von 1300 cm⁻¹ - 1600 cm⁻¹ auftreten. Aus den Röntgen- und Ramanuntersuchungen kann man ableiten, dass die Schicht aus einer Mischung von nanokristallinem und amorphem SiC besteht.

Mittels WDX-Untersuchung wurde ein Chlorgehalt innerhalb der Schichten von 0, 5 At.-% ermittelt.

Mittels eines Vickers-Mikrohärteindenters wurde eine Härte von 3600 HV[0.01] bestimmt.

Die erfindungsgemäße Schicht zeichnet sich durch eine Struktur aus nanokristallinem 3C-SiC und amorphem SiC aus, weist eine glatte Oberfläche auf und besitzt eine hohe Härte.

### Beispiel 3

Auf Si₃N₄-Keramikwendeschneidplatten wird die erfindungsgemäße Schicht direkt mittels eines CVD-Prozesses abgeschieden.
Die Schichtabscheidung erfolgt in einem Heißwand-CVD-Reaktor mit einem Innendurchmesser von 75 mm. Unter Verwendung der Gasmischung aus 0,3 Vol.-% Si₃Cl₈, 93,7 Vol.-% H₂ und 6,0 Vol.-% C₂H₄ bei einer Temperatur von 900°C und einem Druck von 9 kPa wird nach einer Beschichtungszeit von 120 min eine 3,6 µm dicke SiC-Schicht erhalten.

Diese Schicht wurde ebenfalls mittels röntgenographischer Dünnschichtanalyse im streifenden Einfall untersucht (siehe Röntgendiffraktogramm Abb. 4). Die 3C-SiC Reflexe haben eine geringere Breite und sind deutlich stärker ausgeprägt als bei Ausführungsbeispiel 2. Mit Hilfe der Scherrer-Gleichung wurde eine 3C-SiC-Korngröße von 20 nm bestimmt.

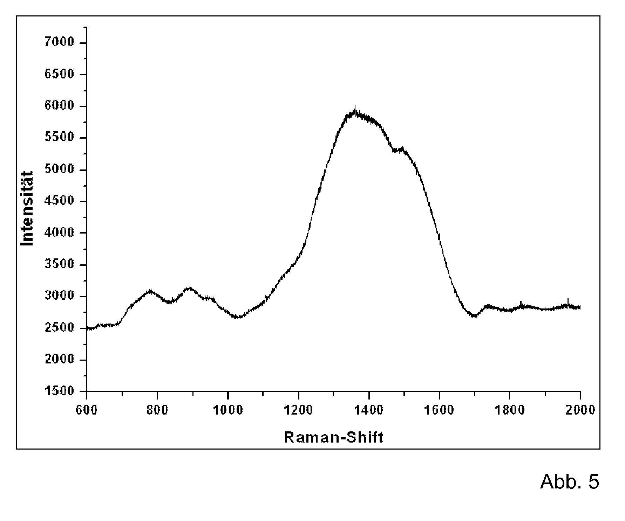

Raman-Untersuchungen (siehe Abb. 5) zeigen die im Vergleich mit Beispiel 2 deutlicher ausgeprägten Peaks des 3C-SiC bei 780 und 890 cm⁻¹. Zusätzlich weist das Spektrum einen breiten Peak im Bereich von 1300 bis 1550 cm⁻¹ auf. Dieser Peak zeigt, dass diese Schicht amorphen, graphitähnlichen Kohlenstoff neben nanokristallinem 3C-SiC enthält.

Mittels WDX-Untersuchung wurde ein Chlorgehalt innerhalb der Schichten von 0,16 At.-% ermittelt.

Mikrohärtemessungen mit einem Vickers-Indenter ergaben eine Härte von 3650 HV[0.01].

Die erfindungsgemäße Schicht besteht aus einer Mischung von nanokristallinem 3C-SiC und amorphem Kohlenstoff und zeichnet sich durch eine glatte Oberfläche und hohe Härte aus.

## Patentansprüche

1. Körper, beschichtet mit einer SiC-Schicht oder mit einem mehrlagigen Schichtsystem, das mindestens eine SiC-Schicht enthält,
wobei die SiC-Schicht aus halogenhaltigem nanokristallinem 3C-SiC oder aus einer Mischschicht besteht, welche aus halogenhaltigem nanokristallinem 3C-SiC und amorphem SiC oder aus halogenhaltigem nanokristallinem 3C-SiC und amorphem Kohlenstoff besteht, und
das nanokristalline 3C-SiC eine Kristallitgröße < 200 nm aufweist.

2. Körper nach Anspruch 1, **dadurch gekennzeichnet, dass** die SiC-Schicht eine clusterfreie, homogene Struktur aufweist.

3. Körper nach Anspruch 1, **dadurch gekennzeichnet, dass** die SiC-Schicht ein periodisch oder kontinuierlich variierendes Verhältnis von halogenhaltigem nanokristallinem 3C-SiC zu amorphem SiC oder amorphem Kohlenstoff aufweist.

4. Körper nach Anspruch 1, **dadurch gekennzeichnet, dass** der Halogengehalt in der SiC-Schicht im Bereich von 0,0001 At.-% bis 2 At.-% liegt.

5. Körper nach Anspruch 1, **dadurch gekennzeichnet, dass** das amorphe SiC ein C:Si-Atomverhältnis von 1 bis 1,2 aufweist.

6. Körper nach Anspruch 1, **dadurch gekennzeichnet, dass** das nanokristalline 3C-SiC amorphen Kohlenstoff mit einem Anteil von 0 bis 10 Ma.-% enthält.

7. Körper nach Anspruch 1, **dadurch gekennzeichnet, dass** das mehrlagige Schichtsystem aus mehreren SiC-Schichten oder aus mindestens einer SiC-Schicht und einer oder mehrer Schichten, ausgewählt aus einer Gruppe der Materialien TiN, TiCN, TiC, Al₂O₃ und Diamant, besteht.

8. Körper nach Anspruch 1, **dadurch gekennzeichnet, dass** die SiC-Schicht unter Vermeidung einer Zwischenschicht unmittelbar auf dem Körper angeordnet ist.

9. Körper nach Anspruch 1, **dadurch gekennzeichnet, dass** die SiC-Schicht oder das mehrlagige Schichtsystem auf Körpern aus Metall, Hartmetall, Cermet oder Keramik als Verschleiß- oder Oxidationsschutzschicht oder für Anwendungen in der Mikroelektronik oder der Photovoltaik aufgebracht ist.

10. Verfahren zur Beschichtung von Körpern mit einer SiC-Schicht oder mit einem mehrlagigen Schichtsystem, das mindestens eine SiC-Schicht enthält, wobei die SiC-Schicht aus halogenhaltigem nanokristallinem 3C-SiC oder aus einer Mischschicht besteht, welche aus halogenhaltigem nanokristallinem 3C-SiC und amorphem SiC oder aus halogenhaltigem nanokristallinem 3C-SiC und amorphem Kohlenstoff besteht, **dadurch gekennzeichnet, dass** die Körper mittels eines thermischen CVD-Prozesses bei Temperaturen zwischen 600°C und 950°C und bei einem Druck im Bereich von 1 kPa bis 9 kPa beschichtet werden, wobei eine Gasmischung verwendet wird,
- die H₂ und/oder eines oder mehrere Inertgase, eines oder mehrere der Halogenpolysilane der Formeln SiₙX₂ₙ, SiₙX₂ₙ₊₂, SiₙX_{y}H_{z} worin X das Halogen und n ≥ 2 ist, sowie einen oder mehrere Kohlenwasserstoffe enthält, oder
- die H₂ und/oder eines oder mehrere Inertgase, eines oder mehrere, mit organischen Substituenten R substituierte Halogenpolysilane der allgemeinen Formeln SiₙX_{y}R_{z} und/oder SiₙHₓX_{y}R_{z} enthält,
worin X das Halogen ist und n ≥ 2, z > 0, y ≥ 1 sind und für SiₙX_{y}R_{z} die stöchiometrischen Beziehungen 2n+2 = y+z oder 2n = y+z und für SiₙHₓX_{y}R_{z} die stöchiometrischen Beziehungen 2n+2 = x+y+z oder 2n = x+y+z gelten, und wobei das nanokristalline 3C-SiC eine Kristallitgröße < 200 nm aufweist.

11. Verfahren nach Anspruch 10, **dadurch gekennzeichnet, dass** als Halogenpolysilane Si₂X₆, Si₃X₈, Si₄X₈, Si₄X₁₀, Si₅X₁₀, Si₅X₁₂, Si₆X₁₂ eingesetzt werden, wobei X = Cl, F, Br und/oder I sind.

12. Verfahren nach Anspruch 10, **dadurch gekennzeichnet, dass** die Körper mittels eines thermischen CVD-Prozesses bei Temperaturen zwischen 600°C und 800°C beschichtet werden.

13. Verfahren nach Anspruch 10, **dadurch gekennzeichnet, dass** als organischer Substituent CH₃ dient.

14. Verfahren nach Anspruch 10, **dadurch gekennzeichnet, dass** als Halogenpolysilane mit organischen Substituenten (CH₃)₂Si₂Cl₄ und/oder (CH₃)₄Si₂Cl₂ in der Gasmischung verwendet werden.

15. Verfahren nach Anspruch 10, **dadurch gekennzeichnet, dass** als Kohlenwasserstoffe Alkane, Alkene oder Alkine, insbesondere CH₄, C₂H₄ oder C₂H₂, eingesetzt werden.

## Claims

1. Bodies coated with an SiC layer or with a multilayer coating system that contains at least an SiC layer, wherein the SiC layer consists of halogen-containing nanocrystalline 3C-SiC or a mixed layer, which consists of halogen-containing nanocrystalline 3C-SiC and amorphous SiC or halogen-containing nanocrystalline 3C-SiC and amorphous carbon, and the nanocrystalline 3C-SiC has a crystallite size of < 200 nm.

2. Bodies according to Claim 1, **characterized in that** the SiC layer shows a cluster-free, homogeneous structure.

3. Bodies according to Claim 1, **characterized in that** the SiC layer shows a periodically or continuously varying ratio of halogen-containing nanocrystalline 3C-SiC to amorphous SiC or amorphous carbon.

4. Bodies according to Claim 1, **characterized in that** the halogen content in the SiC layer is in the range of 0.0001 atm % to 2 atm %.

5. Bodies according to Claim 1, **characterized in that** the amorphous SiC has a C : Si atomic ratio of 1 to 1.2.

6. Bodies according to Claim 1, **characterized in that** the nanocrystalline 3C-SiC contains amorphous carbon in an amount of 0 to 10 mass %.

7. Bodies according to Claim 1, **characterized in that** the multilayer coating system consists of several SiC layers or at least one SiC layer and one or more layers selected from the group of materials TiN, TiCN, TiC, Al₂O₃, and diamond.

8. Bodies according to Claim 1, **characterized in that** the SiC layer is placed directly on the body, avoiding the use of an intermediate layer.

9. Bodies according to Claim 1, **characterized in that** the SiC layer or the multilayer coating system is applied to bodies of metal, hard metal, cermet, or ceramic as a wear protection or antioxidant layer or for applications in microelectronics or photovoltaics.

10. Process for the coating of bodies with an SiC layer or with a multilayer coating system that contains at least an SiC layer, wherein the SiC layer consists of halogen-containing nanocrystalline 3C-SiC or a mixed layer, which consists of halogen-containing nanocrystalline 3C-SiC and amorphous SiC or halogen-containing nanocrystalline 3C-SiC and amorphous carbon, **characterized in that** the bodies are coated by means of a thermal CVD process at temperatures between 600°C and 950°C and at a pressure in the range of 1 kPa to 9 kPa, wherein a gas mixture is used
- that contains H₂ and/or one or more inert gases, one or more of the halogen polysilanes of the formulas SiₙX₂ₙ, SiₙX₂ₙ₊₂, or SiₙX_{y}H_{z}, wherein X is the halogen and n is ≥ 2,
and one or more hydrocarbons, or
- H₂ and/or one or more inert gases that contains one or more halogen polysilanes substituted with organic substituents R and having the general formulas SiₙX_{y}R_{z}, or SiₙHₓX_{y}R_{z},
and wherein X is the halogen and n ≥ 2, z > 0, and y ≥ 1, the stoichiometric relationships 2n + 2 = y + z or 2n = y + z apply for SiₙX_{y}R_{z}, and the stoichiometric relationships 2n + 2 = x + y + z or 2n = x + y + z apply for SiₙHₓX_{y}R_{z}, and wherein the nanocrystalline 3C-SiC has a crystallite size of < 200 nm.

11. Process according to Claim 10, **characterized in that** Si₂X₆, Si₃X₈, Si₄X₈, Si₄X₁₀, Si₅X₁₀, Si₅X₁₂, and Si₆X₁₂ are used as halogen polysilanes, wherein X = Cl, F, Br, and/or I.

12. Process according to Claim 10, **characterized in that** the bodies are coated by means of a thermal CVD process.

13. Process according to Claim 10, **characterized in that** CH₃ serves as an organic substituent.

14. Process according to Claim 10, **characterized in that** (CH₃)₂Si₂Cl₄ and/or (CH₃)₄Si₂Cl₂ are used in the gas mixture as halogen polysilanes with organic substituents.

15. Process according to Claim 10, **characterized in that** alkanes, alkenes, or alkynes CH₄, C₂H₄, or C₂H₂, in particular are used as hydrocarbons.

## Revendications

1. Corps, revêtu avec une couche de SiC ou avec un système stratifié multicouche qui contient au moins une couche de SiC,
la couche de SiC consistant en 3C-SiC nanocristallin halogéné ou en une couche mixte qui est constituée de 3C-SiC nanocristallin halogéné et de SiC amorphe ou de 3C-SiC nanocristallin halogéné et de carbone amorphe, et
le 3C-SiC nanocristallin présente une taille de cristallite < 200 nm.

2. Corps selon la revendication 1, **caractérisé en ce que** la couche de SiC présente une structure homogène sans agrégats.

3. Corps selon la revendication 1, **caractérisé en ce que** la couche de SiC présente un rapport, variant périodiquement ou en continu, de 3C-SiC nanocristallin halogéné à SiC amorphe ou carbone amorphe.

4. Corps selon la revendication 1, **caractérisé en ce que** la teneur en halogène de la couche de SiC se situe dans la plage de 0,0001 % en atomes à 2 % en atomes.

5. Corps selon la revendication 1, **caractérisé en ce que** le SiC amorphe présente un rapport d'atomes de C:Si de 1 à 1,2.

6. Corps selon la revendication 1, **caractérisé en ce que** le 3C-SiC nanocristallin contient du carbone amorphe en une proportion de 0 à 10 % en masse.

7. Corps selon la revendication 1, **caractérisé en ce que** le système stratifié multicouche est constitué de plusieurs couches de SiC ou d'au moins une couche de SiC et d'une ou de plusieurs couches choisies dans un groupe des matériaux TiN, TiCN, TiC, Al₂O₃ et diamant.

8. Corps selon la revendication 1, **caractérisé en ce que** la couche de SiC est disposée directement sur le corps, sans utilisation d'une couche intermédiaire.

9. Corps selon la revendication 1, **caractérisé en ce que** la couche de SiC ou le système stratifié multicouche est déposé(e) sur des corps en métal, métal dur, cermet ou céramique, en tant que couche de protection contre l'usure ou l'oxydation ou pour des applications en microélectronique ou en photovoltaïque.

10. Procédé pour le revêtement de corps avec une couche de SiC ou avec un système stratifié multicouche qui contient au moins une couche de SiC, la couche de SiC consistant en 3C-SiC nanocristallin halogéné ou en une couche mixte qui est constituée de 3C-SiC nanocristallin halogéné et de SiC amorphe ou de 3C-SiC nanocristallin halogéné et de carbone amorphe, **caractérisé en ce qu'**on revêt les corps au moyen d'un processus CVD thermique à des températures comprises entre 600 °C et 950 °C et sous une pression dans la plage de 1 kPa à 9 kPa, en utilisant un mélange de gaz,
- qui contient H₂ et/ou un ou plusieurs gaz inertes, un ou plusieurs des halogénopolysilanes de formules SiₙX₂ₙ, SiₙX₂ₙ₊₂, SiₙX_{y}H_{z}, où X est l'halogène et n est ≥ 2, ainsi qu'un ou plusieurs hydrocarbures, ou
- qui contient H₂ et/ou un ou plusieurs gaz inertes, un ou plusieurs halogénopolysilanes substitués par des substituants organiques R, de formules générales SiₙX_{y}R_{z} et/ou SiₙHₓX_{y}R_{z},
où X est l'halogène et n est ≥ 2, z est > 0, y est ≥ 1 et pour SiₙX_{y}R_{z} s'appliquent les relations stoechiométriques 2n+2 = y+z ou 2n = y+z et pour SiₙHₓX_{y}R_{z} s'appliquent les relations stoechiométriques 2n+2 = x+y+z ou 2n = x+y+z, et le 3C-SiC nanocristallin présentant une taille de cristallite < 200 nm.

11. Procédé selon la revendication 10, **caractérisé en ce qu'**on utilise comme halogénopolysilanes Si₂X₆, Si₃X₈, Si₄X₈, Si₄X₁₀, Si₅X₁₀, Si₅X₁₂, Si₆X₁₂, X représentant Cl, F, Br et/ou I.

12. Procédé selon la revendication 10, **caractérisé en ce qu'**on revêt les corps au moyen d'un processus CVD thermique à des températures comprises entre 600 °C et 800 °C.

13. Procédé selon la revendication 10, **caractérisé en ce que** CH₃ sert de substituant organique.

14. Procédé selon la revendication 10, **caractérisé en ce que** dans le mélange de gaz on utilise comme halogénopolysilanes à substituants organiques (CH₃)₂Si₂Cl₄ et/ou (CH₃)₄Si₂Cl₂.

15. Procédé selon la revendication 10, **caractérisé en ce qu'**on utilise comme hydrocarbures des alcanes, alcènes ou alcynes, en particulier CH₄, C₂H₄ ou C₂H₂.
